# EUROPÄISCHE PATENTANMELDUNG

(11) **EP 4 030 623 A1**
(43) Veröffentlichungstag der Anmeldung: **20.07.2022**
(21) Anmeldenummer: 22000003.8
(22) Anmeldetag: 04.01.2022
(51) Int. Cl.: H03K 17/95

(54) **INDUKTIVE SENSOREINHEIT UND ÜBERWACHUNGSVERFAHREN**

(30) Priorität: 15.01.2021 DE 102021000155
(71) Anmelder: Pepperl+Fuchs SE, 68307 Mannheim (DE)
(72) Erfinder: Braunsmann, Christoph, 68307 Mannheim (DE)
(74) Vertreter: Koch Müller Patentanwaltsgesellschaft mbH

(57) **Zusammenfassung**

Induktive Sensoreinheit zum Erfassen eines Abstandes zu einem metallischen Gegenstand und Überwachungsverfahren, die Sensoreinheit aufweisend wenigstens eine Spuleneinheit mit einer Sensorspule mit einer Induktivität und einem Wirkwiderstand, wobei die Sensorspule mit einem Anregungssignal beaufschlagt ist, eine Auswerteeinheit zum Ermitteln des Abstands, einer Schaltungseinheit zum Bestimmen eines Istwerts der Induktivität der Sensorspule und / oder eines Istwerts des Wirkwiderstands der Sensorspule und/oder eine zu dem Istwert der Induktivität oder zu dem Istwert des Wirkwiderstands in einem funktionalen Zusammenhang stehende abgeleitete Größe und die Schaltungseinheit zur Überwachung der Sensorspule aus dem Vergleich eines oder mehreren der Istwerte und / oder der abgeleiteten Größe mit jeweils einem zugeordneten in einer Speichereinheit abgelegten Sollwert ein Diagnosesignal bestimmt.

## Beschreibung

Die Erfindung betrifft eine induktive Sensoreinheit zum Ermitteln eines Abstands sowie ein Verfahren zur Überwachung einer induktiven Sensoreinheit.

Eine induktive Sensoreinheit in Form eines Näherungsschalters ist aus der DE 10 2017 128 472 A1 bekannt. Der Näherungsschalter weist einem Schwingkreis mit einer Sensorspule und einem Kondensator auf, wobei während des Betriebs ein Ist-Wert der Induktivität der Sensorspule des Schwingkreises gemessen, z.B. mittels eines Lock-In-Verstärkers, und die Sensoreinheit, also z.B. der Schwingkreis, der Oszillatorverstärker und/oder die Ausgangsstufe, in Abhängigkeit von der gemessenen Induktivität eingestellt wird. Hierdurch wird der Einfluss temperaturbedingter Induktivitätsänderungen der Sensorspule auf den Schaltabstand reduziert oder sogar vollständig kompensiert.

Eine weitere induktive Sensoreinheit mit Kompensation temperaturbedingter Induktivitätsänderungen ist aus der DE 10 2017 130 122 A1 bekannt. Die Sensoreinheit weist eine Sensorspule, aber keinen LC-Schwingkreis auf und arbeitet nach dem sogenannten Pulsauswerteverfahren. Die Sensorspule wird während eines Anregungszeitraums mit einem Strompuls angeregt und während eines sich anschließenden Sperrzeitraums von der Stromquelle getrennt. Um eine Änderung der Induktivität und / oder des Wirkwiderstands der Sensorspule zu ermitteln, wird der Strom oder die Spannung an der Sensorspule bereits während des Anregungszeitraums abgetastet. Ermittelte Änderungen werden zur Kompensation eines während des Sperrzeitraums abgetasteten Impulsantwortsignals zur Abstandsermittlung verwendet.

Aus der EP 0 049 304 A1, der EP 0 813 306 B1, der EP 0 303 563 A2, der DE 101 47 817 A1, der DE 44 45 819 A1 und der DE 10 2013 202 573 B3 sind weitere gattungsgemäße Sensoreinheiten bekannt.

Aus der DE 20 2011 001 009 U1 wird anhand einer Messung der Spulengüte und eines Vergleichs mit einem Ist-Wert ein Diagnose- bzw. Warnsignal erzeugt und ausgegeben.

Weitere Diagnosefunktionen für Näherungsschalter sind aus der DE 11 2011 102 725 T5 und der DE 10 2009 046 691 B4 bekannt.

Vor diesem Hintergrund besteht die Aufgabe der Erfindung darin, eine Vorrichtung anzugeben, die den Stand der Technik weiterbildet. Insbesondere soll eine Sensoreinheit mit vereinfachter Wartung und verbesserter Ausfalldetektion bereitgestellt werden.

Die Aufgabe wird durch eine induktive Sensoreinheit mit den Merkmalen des Patentanspruchs 1 sowie durch ein Verfahren mit den Merkmalen des Patentanspruchs 14 gelöst. Vorteilhafte Ausgestaltungen der Erfindung sind Gegenstand von Unteransprüchen.

Gemäß dem Gegenstand der Erfindung wird eine induktive Sensoreinheit zum Ermitteln eines Abstands zu einem metallischen Gegenstand bereitgestellt, aufweisend wenigstens eine Spuleneinheit mit einer Sensorspule mit einer Induktivität und einem Wirkwiderstand, wobei die Sensorspule mit einem Anregungssignal beaufschlagt ist.

Die induktive Sensoreinheit weist weiterhin eine Auswerteeinheit zum Ermitteln des Abstands, eine Schaltungseinheit zum Bestimmen eines Istwerts der Induktivität der Sensorspule und / oder eines Istwerts des Wirkwiderstands der Sensorspule auf.

Zusätzlich oder alternativ ist die Auswerteeinheit eingerichtet, eine zu dem Istwert der Induktivität und / oder zu dem Istwert des Wirkwiderstands in einem funktionalen Zusammenhang stehenden abgeleiteten Größe zu bestimmen.

Die Schaltungseinheit ist dazu ausgelegt, zur Überwachung der Sensoreinheit aus dem Vergleich eines oder mehreren der Istwerte und / oder der abgeleiteten Größe mit jeweils einem zugeordneten in einer Speichereinheit abgelegten Sollwert ein Diagnosesignal zu bestimmen.

Gemäß einem weiteren Aspekt der Erfindung wird ein Verfahren zur Überwachung einer Spuleneinheit einer induktiven Sensoreinheit zum Erfassen eines Abstandes zu einem metallischen Gegenstand bereitgestellt.

Die Sensoreinheit weist eine Sensorspule mit einer Induktivität und einem Wirkwiderstand, eine Auswerteeinheit zum Ermitteln des Abstandes und einer Schaltungseinheit auf, wobei die Sensorspule mit einem Signal beaufschlagt wird.

Mit der Schaltungseinheit wird ein Istwert der Induktivität und / oder ein Istwert des Wirkwiderstands und / oder eine zu dem Istwert der Induktivität und / oder eine zu dem Istwert des Wirkwiderstands in einem funktionalen Zusammenhang stehende abgeleitete Größe bestimmt.

Mittels der Schaltungseinheit wird außerdem aus einem Vergleich eines Istwertes oder mehrerer der Istwerte und / oder der abgeleiteten Größen mit jeweils einem zugeordneten in einer Speichereinheit abgelegten Sollwert ein Diagnosesignal bestimmt, um eine Überwachung der Sensoreinheit durchzuführen.

Überraschenderweise zeigte sich, dass sich aus der Überwachung der Sensoreinheit aus dem Vergleich von Istwerten mit Sollwerten die Zuverlässigkeit der Anordnung erhöhen lässt.

Das Grundprinzip einer induktiven Sensoreinheit beruht auf einer Änderung der Induktivität bzw. der Güte der Sensorspule bei Annäherung eines metallischen Gegenstands.

Die Sensorspule bildet beispielsweise zusammen mit einem Kondensator einen Schwingkreis (LCR-Oszillator), wobei der Schwingkreis mittels eines Oszillatorverstärkers bei einer Resonanzfrequenz betrieben wird.

Alternativ wird die Sensorspule mittels eines Strompulses bzw. periodisch wiederkehrender Strompulse angeregt und nach dem sogenannten Pulsauswerteverfahren ausgewertet.

Das mittels des Strompulses oder der Schwingung des Schwingkreises von der Spule erzeugte Magnetfeld induziert ab einem ausreichend geringen Abstand eines sich nähernden metallischen Gegenstands Wirbelströme in dem Gegenstand.

Die induzierten Wirbelströme führen aufgrund der magnetischen Kopplung zwischen dem metallischen Gegenstand und dem Schwingkreis bzw. der Spule zu einer Änderung der Frequenz und / oder der Amplitude des Schwingkreises bzw. des von der Spule empfangenen Pulsantwortsignals. Anders ausgedrückt der Selbstinduktions-Spannungspuls der durch den einzelnen Spannungspuls angeregten Sensorspule wird verändert.

Anhand der Änderung lässt sich zumindest die Anwesenheit des metallischen Objekts und / oder die Art des metallischen Objekts und / oder der Abstand des metallischen Objekts und / oder das Erreichen eines Schaltabstands ermitteln.

Eine Änderung der Induktivität der Sensorspule und / oder des Wirkwiderstands der Spule, die zu einer Änderung der Schwingkreisamplitude und / oder -frequenz bzw. zu einer Änderung der Spulenspannung führt, wird auch durch andere Einflüsse verursacht, z.B. durch Temperaturänderungen, Störsignale, fehlerhafte elektrische Verbindungen, Desakkommodation des Spulenkerns, einen Kernbruch und durch externe Magnetfelder.

Ein Vorteil der Überwachung ist es, dass sich auf Basis einer zusätzlichen vom Objektabstand weitestgehend unabhängigen Messung der Induktivität und / oder des Wirkwiderstands der Sensorspule durchführen lässt, um insbesondere die Verfälschung der Abstandsmessung durch die vorgenannt beschriebenen anderen Einflüsse besonders vorteilhaft zu korrigieren.

Es versteht sich, dass der Korrektur natürlich Grenzen gesetzt sind, indem bei einer gemessenen Induktivitäts- bzw. Wirkwiderstandsänderung durch unterschiedliche Einflussarten nicht zwangsläufig von einer gleich großen Beeinflussung der Abstandsmessung auszugehen ist.

So wird z.B. ein ferritkernsättigendes externes Magnetfeld die Abstandsmessung tendenziell anders beeinflussen, wie eine Desakkommodation des Ferritkerns.

Des Weiteren lässt sich die gemessene Induktivität bzw. der Wirkwiderstand der Sensorspule auf unregelmäßige zeitliche Verläufe wie z.B. sprunghafte Änderungen untersuchen, welche z.B. auf Kernbrüche oder fehlerhafte elektrische Verbindungen hinweisen. Derartige Änderungen sind Indikatoren für einen baldigen Totalausfall des Sensors.

Erfindungsgemäß ist die Schaltungseinheit daher dazu ausgelegt, die Induktivität und / oder den Wirkwiderstand der Sensorspule zu überwachen, d.h. einmal oder mehrmals einen Istwert der Induktivität und / oder des Wirkwiderstands und / oder einer zu diesen Werten in einem funktionalen Zusammenhang stehenden abgeleiteten Größe zu ermitteln und mit einem entsprechenden Sollwert zu vergleichen und ein Diagnosesignal bereitzustellen.

Beispielsweise weist die Sensoreinheit eine modulierte Stromquelle zum Einprägen eines Teststroms in den Schwingkreis und einen Lock-In-Verstärker zum Zerlegen des Stromabfalls an einem Strommesswiderstand in einen Real- und Imaginärteil auf. Alternativ wird der Strom bzw. die Spannung an den beiden Enden der durch Strompulse angeregten Sensorspule abgegriffen.

Die Überwachung der Induktivität und / oder des Wirkwiderstands, hat viele Vorteile. Insbesondere lässt sich durch ein getrenntes Erfassens der Größen oder einer der Größen die Ursache einer Störung genauer eingrenzen als bei einer Messung der Spulengüte.

Beispielsweise lässt sich anhand des Wirkwiderstandes feststellen, ob die Sensoreinheit bei zu hohen Temperaturen eingesetzt wird oder wurde, die schädlich für einige der Elektronik-Bauteile oder auch die Vergussmasse sein könnten. Auch fehlerhafte Lötkontakte, Crimp-Verbindungen oder Lötverbindungen zwischen der Sensorspule und weiteren Bauteilen sind feststellbar. Untersuchungen haben nämlich gezeigt, dass sich die Temperatur aus dem Wert des Wirkwiderstands der Spule ableiten lässt. Insbesondere ändert sich der Wirkwiderstand der Spule weitestgehend linear mit der Temperatur, demhingenen ist die Abhängigkeit der Induktivität von Temperatur hochgradig nichtlinear.

Der Wirkwiderstand der Sensorspule ändert sich beispielsweise sowohl aufgrund einer temperaturbedingten Änderung der Leitfähigkeit als auch aufgrund eines Litzendrahtbruchs, z.B. durch Alterung oder durch mechanische Beanspruchung. Die Induktivität ändert sich beispielsweise bei einem Bruch oder einer Magnetostriktion des Ferritkerns, z.B. aufgrund mechanischer Beanspruchung.

Das Diagnosesignal dient entsprechend beispielsweise direkt als Warnsignal und weist auf ein aktuelles Problem hin. Gemäß einer anderen Ausführungsform wird das Diagnosesignal aufgezeichnet und beispielsweise zu Wartungszwecken herangezogen.

Das Diagnosesignal enthält Informationen über die Art des aufgetretenen Fehlers oder Vorfalls. Beispielsweise werden in Abhängigkeit von der Größe einer Impedanzänderung Warnsignale gemäß eines mehrstufigen Warnsystems ausgegeben.

Gemäß einer Ausführungsform weisen die Schaltungseinheit und die Auswerteeinheit jeweils eine eigene Recheneinheit auf. Alternativ werden die Schaltungseinheit und die Auswerteeinheit zumindest in Teilen durch dieselbe Recheneinheit ausgebildet.

Gemäß einer anderen Ausführungsform ist das Diagnosesignal ausgebildet, unterschiedliche Arten von Fehlern abzubilden. Beispielsweise kann zwischen plötzlich auftretenden Störungen, z.B. einem Litzendrahtbruch oder auch eines Bruchs des Ferritkerns oder kalte Lötstellen, und langsamen Prozessen, z.B. aufgrund von Alterungsprozessen wie Korrosion, unterschieden werden.

In einer anderen Ausführungsform umfasst das Anregungssignal einzelne zeitlich voneinander beabstandete Pulse oder eine Schwingung. Während eine in einem Schwingkreis betriebene Sensorspule typischerweise mit einer Schwingung als Anregungssignal angeregt wird, wird eine einzeln betriebene Sensorspule in der Regel mittels einzelner periodisch wiederkehrender Strompulse angeregt.

Gemäß einer weiteren Ausführungsform umfasst die Spuleneinheit einen Temperatursensor und der Temperatursensor ist thermisch mit der Sensorspule gekoppelt. Die Messwerte des Temperatursensor werden beispielsweise als zusätzliche Information mit dem Diagnosesignal ausgegeben und / oder bei einer Auswertung des Diagnosesignals berücksichtigt.

Beispielsweise wird eine monoton steigende oder sinkende Temperaturänderung mittels des Temperatursensors erfasst, während gleichzeitig der Spulenwiderstand ermittelt wird. Weist der ermittelte Spulenwiderstand keinen mit der Temperaturänderung korrelierenden sondern einen sprunghaften Verlauf auf, so weist dies auf temporäre Litzendrahtbrüche bzw. Wackelkontakte hin.

In einer anderen Weiterbildung ist die Schaltungseinheit eingerichtet, bei der Bestimmung des Diagnosesignals wenigstens einen Wert des Temperatursensors zu berücksichtigen.

Gemäß einer weiteren Weiterbildung steht die Schaltungseinheit mit einer Steuereinheit in einer Wirkverbindung und das Diagnosesignal liegt als analoges Signal und / oder als digitales Signal an der Steuereinheit an.

In einer anderen Ausführungsform ist die Schaltungseinheit mit einer Ausgabeeinheit verschaltet und die Ausgabeeinheit gibt das Diagnosesignal visuell oder akustisch aus.

Gemäß einer weiteren Ausführungsform korreliert wenigstens eine Eigenschaft des Diagnosesignals mit der Größe der Abweichung wenigstens eines der zur Bestimmung des Diagnosesignals verwendeten Werte.

In einer anderen Weiterbildung werden mehrere Diagnosesignale bestimmt, wobei die einzelnen Diagnosesignale jeweils einen Zeitstempel aufweisen. So können auftretende Störungen im Rahmen einer Wartung auch zeitlich nachvollzogen bzw. ausgewertet werden.

Gemäß einer weiteren Weiterbildung ist die Speichereinheit eingerichtet, die Istwerte und / oder das Diagnosesignal zu speichern.

In einer anderen Ausführungsform ist die Schaltungseinheit dazu ausgelegt, an mehreren Zeitpunkten Istwerte zu bestimmen. So kann der zeitliche Verlauf der Istwerte analysiert werden.

Gemäß einer weiteren Ausführungsform ist die Schaltungseinheit ausgelegt, den Wirkwiderstand und / oder die Induktivität und / oder die abgeleitete Größe aus dem zeitlichen Verlauf der Spulenspannung zu bestimmen.

In einer anderen Weiterbildung ist eine Pulsfrequenz zur Bestimmung des Wirkwiderstandes und / oder der Induktivität identisch mit der Pulsfrequenz zur Bestimmung des Objektabstandes.

In einer weiteren Weiterbildung ist die Spuleneinheit mit der Auswerteeinheit mittels eines Kabels verschaltet und das Kabel weist eine Länge von mindestens 1 m und maximal 50 m oder maximal 30 m auf. Beispielsweise ist die Auswerteeinheit mit einem 20 m langen Kabel mit der Spuleneinheit verbunden.

Gemäß einer ersten Ausführungsform des Verfahrens zur Überwachung einer Sensoreinheit wird zur Bestimmung des Diagnosesignals eine Temperatur der Sensorspule bestimmt.

In einer anderen Ausführungsform wird mittels einer Ausgabeeinheit das Diagnosesignal visuell oder akustisch ausgegeben.

Gemäß einer weiteren Ausführungsform wird wenigstens eine Eigenschaft des Diagnosesignals mit der Größe der Abweichung wenigstens eines der zur Bestimmung des Diagnosesignals verwendeten Werte korreliert.

In einer anderen Weiterbildung werden mehrere Diagnosesignale bestimmt, wobei die einzelnen Diagnosesignale jeweils mit einem Zeitstempel versehen werden.

Gemäß einer weiteren Weiterbildung werden zu mehreren Zeitpunkten Istwerte bestimmt.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1: eine schematische Ansicht auf eine erste Ausführungsform einer induktiven Sensoreinheit,
- Figur 2: eine schematische Ansicht auf eine zweite Ausführungsform der induktiven Sensoreinheit,
- Figur 3: einen beispielhaften Verlauf einer Schalt- und einer Sensorspulenspannung
- Figur 4: eine im Hinblick auf die Überwachung vereinfachte Schaltung der Sensoreinheit des zweiten Ausführungsbeispiels,
- Figur 5: einen beispielhaften Verlauf eines Wirkwiderstands einer Sensorspule.

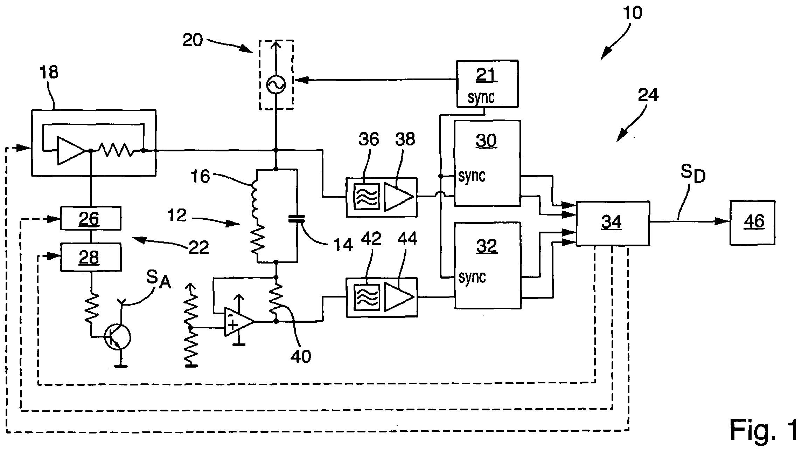

Die Abbildung der Figur 1 zeigt eine erste Ausführungsform einer induktiven Sensoreinheit 10 mit einem LC-Schwingkreis 12 zur Abstandsbestimmung eines metallischen Objekts. Die Sensoreinheit 10 weist den Schwingkreis 12, einen Oszillatorverstärker 18, eine einstellbare Stromquelle 20 mit einem Funktionsgenerator 21 zur Beaufschlagung der Sensoreinheit 10 mit einem Teststrom als Anregungssignal, einer Auswerteeinheit 22 und einer Schalteinrichtung 24.

Der Schwingkreis weist einen Kondensator 14, eine Sensorspule 16 mit einer Induktivität L und einen Wirkwiderstand Rₛ auf. Verluste des Schwingkreises werden durch den Oszillatorverstärker 18 ausgeglichen, so dass der Schwingkreis im Betrieb mit seiner Resonanzfrequenz schwingt.

Die Auswerteeinheit 22 weist einen Gleichrichter 26 zur Amplitudenbestimmung und einen Komparator 28 auf, wobei der Komparator 28 ein Abstandssignal S_{A} über eine Transistorstufe bereitstellt.

Die Schalteinheit 24 weist einen ersten Lock-In-Verstärker 30, einen zweiten Lock-In-Verstärker 32 und eine Recheneinheit 34 auf, wobei der erste Lock-In-Verstärker 30 den vom Teststrom verursachten Spannungsabfall über den Wirkwiderstand Rₛ und der Induktivität L misst und der zweite Lock-In-Verstärker 32 den vom Teststrom verursachten Spannungsabfall über den Strommesswiderstand 40 misst.

Für eine von dem metallischen Objekts bzw. dessen Bewegung unabhängige Bestimmung der Induktivität L bzw. des Wirkwiderstands Rₛ weist der Teststrom bevorzugt eine niedrige Frequenz, z.B. 100 Hz auf. Insbesondere ist die Frequenz des Teststroms deutlich niedriger als die Resonanzfrequenz des Schwingkreises 12.

Die bei dem Schwingkreis 12 anliegende Spannung wird über einen Bandpassfilter 36 zum Herausfiltern der Oszillatorschwingung und einen Verstärker 38 auf einen Eingang des ersten Lock-In-Verstärkers 30 angelegt und mittels des ersten Lock-In-Verstärkers 30 in einen Realteil und einen Imaginärteil zerlegt.

Über einen Strommesswiderstand 40 wird der Teststrom gemessen. Hierfür ist der Strommesswiderstand 40 wiederum über einen Bandpassfilter 42 und einen Verstärker 44 mit einem Eingang des zweiten Lock-In-Verstärkers 32 verbunden und die gemessene Spannung wird mittels des zweiten Lock-In-Verstärkers 32 in einen Realteil und einen Imaginärteil zerlegt.

Die Recheneinheit 34 ist dazu ausgelegt, anhand der Real- und Imaginärteile der Lock-In-Verstärker 30 und 32 einen Istwert der Induktivität L der Sensorspule 16 und / oder einen Istwert des Wirkwiderstands Rₛ der Sensorspule 16 und/oder eine zu dem Istwert der Induktivität L oder zu dem Istwert des Wirkwiderstands Rₛ in einem funktionalen Zusammenhang stehende abgeleitete Größe zu ermitteln und mit einem in einer Speichereinheit hinterlegten Sollwert zu vergleichen. Außerdem ist die Recheneinheit 34 dazu ausgelegt, aus dem Vergleich ein Diagnosesignal S_{D} zu bestimmen.

Das Diagnosesignal S_{D} enthält Informationen über den Zustand der Sensoreinheit und kann daher auf Fehler bzw. Probleme hinweisen, z.B. direkt und / oder bei einem Auslesen bei einem nächsten Wartungsintervall.

Das Diagnosesignal wird gemäß einer ersten Ausführungsform an eine Steuereinheit 46 weitergeleitet.

In einer optionalen Weiterbildung werden die ermittelten Istwerte zusätzlich zu Kompensationszwecken genutzt, also zum Ausgleich von beispielsweise temperaturbedingten Änderungen der Induktivität, soweit dies möglich ist. Beispielsweise ist die Recheneinheit 34 auch dazu ausgelegt aus den ermittelten Istwerten eine Kompensation abzuleiten und den Oszillatorverstärker 18 und / oder den Gleichrichter 26 und / oder den Komparator 28 gegebenenfalls entsprechend einzustellen bzw. zu regeln (gestrichelt dargestellt).

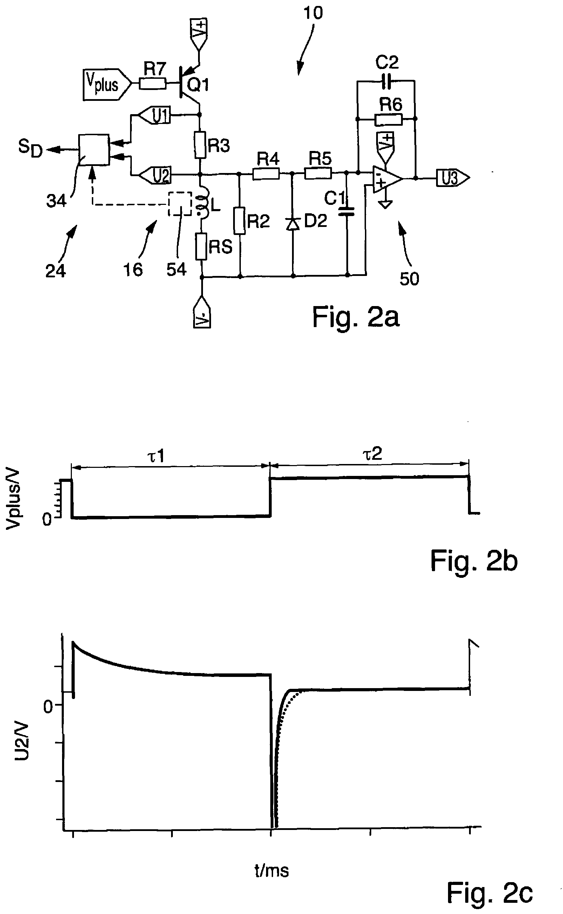

In der Abbildung der Figur 2 ist eine weitere Ausführungsform der Sensoreinheit 10 dargestellt. Im Folgenden werden nur die Unterschiede zu der Abbildung der Figur 1 erläutert.

Im Unterschied zu der ersten Ausführungsform weist die Sensoreinheit 10 gemäß der weiten Ausführungsform keinen LC-Schwingreis 12 auf. Die Sensorspule 16 mit der Induktivität L und dem Wirkwiderstand Rₛ wird über einen Transistor Q1 und einen Widerstand R3 für ein Zeitintervall T₁ mit einer Spannungsquelle V+ als Anregungssignal verbunden und für ein sich anschließendes Zeitintervall T₂ mittels des Transistors Q1 wieder von der Spannungsquelle V+ getrennt. Das entsprechende Steuersignal Vₚₗᵤₛ des Transistors Q1 ist in Abschnitt b der Figur 2 als Funktion der Zeit t dargestellt.

Nach dem Trennen der Sensorspule 16 von der Spannungsquelle V+ führt die Selbstinduktion der Sensorspule 16 zu einem Selbstinduktions-Spannungspuls.

Befindet sich der metallische Gegenstand in der Nähe der Sensoreinheit 10, so erzeugen die in dem Gegenstand induzierten Wirbelströme eine den Selbstinduktions-Spannungspuls überlagernde Spannungspulsantwort in der Sensorspule 16. Der zeitliche Verlauf der Spannung U₂ an der Sensorspule 16 mit (gestrichelt) und ohne (durchgezogene Linie) Gegenstand ist in Abschnitt c der Figur 2 dargestellt.

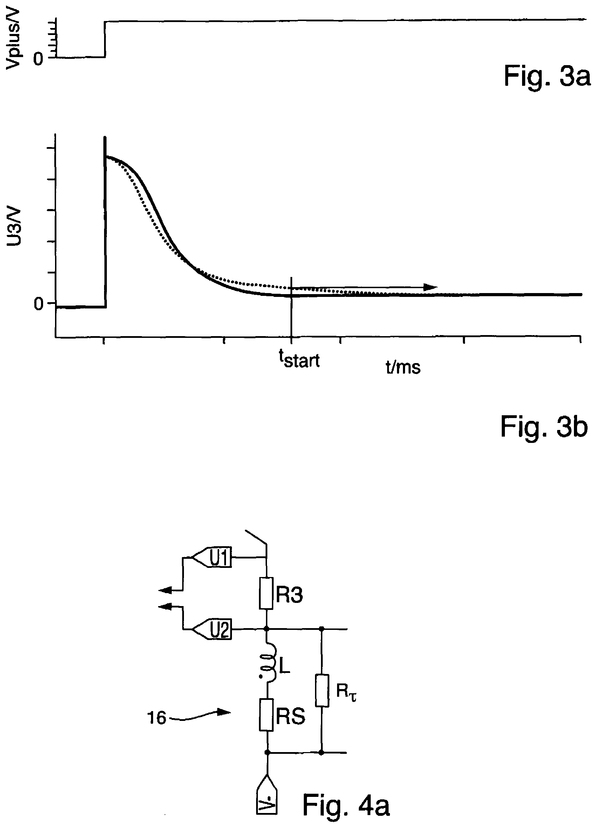

In dem dargestellten Ausführungsbeispiel weist die Sensoreinheit 10 außerdem einen Bedämpfungswiderstand R4, eine die Spulenspannung limitierende Diode D2 und eine Verstärkungsschaltung 50 auf. Eine nach der Verstärkungsschaltung 50 abgreifbare Spannung U₃ der Sensorspule 16 ist in der Abbildung der Figur 3 (unten) zusammen mit dem Steuersignal des Transistors Q1 (oben) dargestellt. Der Unterschied der Spannungsverläufe mit (gestrichelt) und ohne (durchgezogenen Linie) metallischen Gegenstand ist zu erkennen. Der Zeitpunkt tₛₜₐᵣₜ zeigt beispielhaft einen Anfangszeitpunkt für ein Abtasten des Verlaufs der Spannung U₃, um den Abstand des Objekts zu ermitteln.

Die Schaltungseinheit 24 zum Bestimmen eines Istwerts der Induktivität der Sensorspule weist in dem dargestellten Ausführungsbeispiel die Recheneinheit 34 auf, wobei die Recheneinheit 34 zumindest Abtastwerte der Spannung U₂ der Sensorspule 16 und einer Spannung U₁ vor dem Widerstand R3 empfängt.

Optional ist ein Temperatursensor 54 thermisch mit der Sensorspule 16 gekoppelt, wobei die Recheneinheit 34 dazu ausgelegt ist, den Temperatursensor 54 auszulesen und die Ist-Temperatur zu der Bestimmung des Diagnosesignals heranzuziehen.

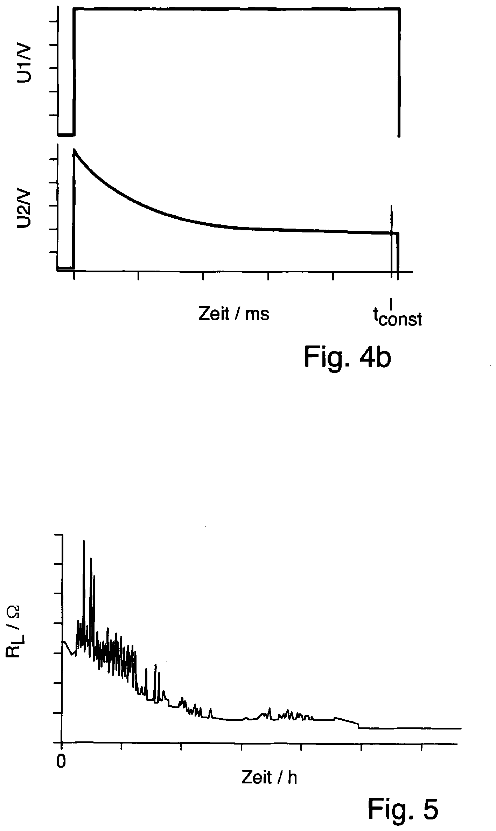

Damit die Bestimmung der Induktivität L bzw. des Wirkwiderstands Rₛ unabhängig von dem metallischen Objekts bzw. dessen Bewegung ist, ist die Schaltungseinheit 24 dazu ausgelegt, die Spannungen U₁ und U₂ in dem Zeitinterwall T₁ abzutasten. Die Verläufe der Spannungen U₁ und U₂ während des Zeitintervalls T₁ sind in der Figur 4 dargestellt.

Wie aus dem vereinfachten Schaltbild im Abschnitt a der Figur 4 hervorgeht, gilt für den Strom durch die Sensorspule 16 I_{L} = I_{R3} - I_{RT}, wobei mit R_{T} ein sich aus der weiteren Schaltung (vergl. Fig. 2) ergebender effektiver Bedämpfungswiderstand bezeichnet wird. Für den Spannungsabfall über der Sensorspule 16 gilt U₂ - V₋ = L dI_{L}/dt + Rₛ I_{L}.

Am Ende des Zeitintervalls T₁ zu einem Zeitpunkt t_{const} stellt sich ein im Wesentlich konstanter Strom durch die Sensorspule ein, so dass für den Wirkwiderstand Rₛ zum Zeitpunkt t_{const} näherungsweise gilt Rₛ = (U₂ - V₋) / I_{L}. Mittels der Näherung kann somit der Istwert des Wirkwiderstand Rₛ zum Zeitpunkt t_{const} und anschließend auch der Istwert der Induktivität L bestimmt werden, z.B. mittels eines Fit des gemessenen Verlaufs der Spannung U₂ mit der Methode der kleinsten Quadrate.

Die Recheneinheit 34 ist außerdem dazu ausgelegt, die ermittelten Istwerte mit einem in einer Speichereinheit hinterlegten Sollwert zu vergleichen und aus dem Vergleich ein Diagnosesignal S_{D} zu bestimmen.

In der Abbildung der Figur 5 ist beispielhaft ein zeitlicher Verlauf des Wirkwiderstands R_{L} der Sensorspule 16 während einer kontinuierlichen Abkühlphase der Sensoreinheit 10 dargestellt. Während die Temperatur monoton sinkt, weist der Verlauf des Wirkwiderstands R_{L} viele und teilweise auch sehr große sprunghafte Änderungen auf. Die sprunghaften Änderungen weisen auf temporäre Litzendrahtbrüche bzw. Wackelkontakte der Sensoreinheit hin.

Mit einer Kompensationseinrichtung könnten bzw. würden die Widerstandsänderungen gegebenenfalls noch kompensiert. Hierdurch würde zwar ein noch fehlerfreies Funktionieren der Sensoreinheit sichergestellt, die Störung selbst würde aber nicht behoben bzw. nicht einmal auffallen.

Die sprunghaften Änderungen des Wirkwiderstands R_{L} stellen eine Abweichung von einem entsprechenden Sollwert dar, so dass die Schaltungseinheit 24 ein entsprechendes Diagnosesignal ermittelt, welches auf den bevorstehenden Ausfall der Sensorspule 16 hinweist.

In einer Ausführungsform ist die Schaltungseinheit 24 dazu ausgelegt, bei einem entsprechend ermittelten Diagnosesignal ein Warnsignal auszugeben, um einen baldigen Austausch der fehlerhaften Sensorspule zu bewirken.

Die erfindungsgemäße Sensoreinheit bzw. das erfindungsgemäße Verfahren stellen somit insbesondere das frühzeitige Erkennen und Identifizieren von Störungen sicher.

## Patentansprüche

1. Induktive Sensoreinheit (10) zum Ermitteln eines Abstandes zu einem metallischen Gegenstand, aufweisend
- wenigstens eine Spuleneinheit mit einer Sensorspule (16) mit einer Induktivität (L) und einem Wirkwiderstand (Rₛ), wobei die Sensorspule (16) mit einem Anregungssignal beaufschlagt ist,
- eine Auswerteeinheit (22) zum Ermitteln des Abstands,
- einer Schaltungseinheit (24) zum Bestimmen eines Istwerts der Induktivität (L) der Sensorspule (16) und / oder eines Istwerts des Wirkwiderstands (Rₛ) der Sensorspule (16) und/oder eine zu dem Istwert der Induktivität (L) oder zu dem Istwert des Wirkwiderstands (Rₛ) in einem funktionalen Zusammenhang stehende abgeleitete Größe,
**dadurch gekennzeichnet, dass**
die Schaltungseinheit (24) dazu ausgelegt ist, zur Überwachung der Sensoreinheit (10) aus dem Vergleich eines Istwerts oder mehrerer Istwerte und / oder der abgeleiteten Größe mit jeweils einem zugeordneten in einer Speichereinheit abgelegten Sollwert ein Diagnosesignal (S_{D}) zu bestimmen.

2. Induktive Sensoreinheit (10) nach Anspruch 1, **dadurch gekennzeichnet, dass** das Diagnosesignal (S_{D}) ausgebildet ist, unterschiedliche Arten von Fehlern abzubilden.

3. Induktive Sensoreinheit (10) nach Anspruch 1 oder Anspruch 2, **dadurch gekennzeichnet, dass** das Anregungssignal einzelne zeitlich voneinander beabstandete Pulse oder eine Schwingung umfasst.

4. Induktive Sensoreinheit (10) nach einem der vorstehenden Ansprüche, **dadurch gekennzeichnet, dass** die Spuleneinheit einen Temperatursensor (52) umfasst und der Temperatursensor thermisch mit der Sensorspule (16) gekoppelt ist.

5. Induktive Sensoreinheit (10) nach Anspruch 4, **dadurch gekennzeichnet, dass** die Schaltungseinheit (24) eingerichtet ist, bei der Bestimmung des Diagnosesignals (S_{D}) wenigstens einen Wert des Temperatursensors (52) zu berücksichtigen.

6. Induktive Sensoreinheit (10) nach einem der vorstehenden Ansprüche, **dadurch gekennzeichnet, dass** die Schaltungseinheit (24) mit einer Steuereinheit (46) in einer Wirkverbindung steht und das Diagnosesignal (S_{D}) als analoges Signal und / oder als digitales Signal an der Steuereinheit (46) anliegt.

7. Induktive Sensoreinheit (10) nach einem der vorstehenden Ansprüche, **dadurch gekennzeichnet, dass** wenigstens eine Eigenschaft des Diagnosesignals (S_{D}) mit der Größe der Abweichung wenigstens eines der zur Bestimmung des Diagnosesignals (S_{D}) verwendeten Werte korreliert.

8. Induktive Sensoreinheit (10) nach einem der vorstehenden Ansprüche, **dadurch gekennzeichnet, dass** die Schaltungseinheit (24) dazu ausgelegt ist, an mehreren Zeitpunkten Istwerte zu bestimmen.

9. Induktive Sensoreinheit (10) nach einem der vorstehenden Ansprüche, **dadurch gekennzeichnet, dass** die Schaltungseinheit (24) ausgelegt ist, den Wirkwiderstand (Rₛ) und / oder die Induktivität (L) und / oder die abgeleitete Größe aus dem zeitlichen Verlauf der Spulenspannung (U₂, U₃) zu bestimmen.

10. Verfahren zur Überwachung einer induktiven Sensoreinheit (10) zum Ermitteln eines Abstandes zu einem metallischen Gegenstand, mit
- einer Sensorspule (16) mit einer Induktivität (L) und einem Wirkwiderstand, wobei die Sensorspule (16) mit einem Anregungssignal beaufschlagt wird,
- einer Auswerteeinheit (22) zum Ermitteln des Abstands,
- einer Schaltungseinheit (24), wobei mit der Schaltungseinheit (24) ein Istwert der Induktivität (L) und / oder ein Istwert des Wirkwiderstands (Rₛ) und / oder eine zu dem Istwert der Induktivität (L) und / oder eine zu dem Istwert des Wirkwiderstands (Rₛ) in einem funktionalen Zusammenhang stehende abgeleitete Größe bestimmt wird,
**dadurch gekennzeichnet, dass**
mittels der Schaltungseinheit (24) aus einem Vergleich eines oder mehrerer der Istwerte und / oder der abgeleiteten Größen mit jeweils einem zugeordneten in einer Speichereinheit abgelegten Sollwert ein Diagnosesignal bestimmt wird, um eine Überwachung der Sensoreinheit (10) durchzuführen.

11. Verfahren zur Überwachung einer Spuleneinheit nach Anspruch 10, **dadurch gekennzeichnet, dass** zur Bestimmung des Diagnosesignals (S_{D}) eine Temperatur der Sensorspule (16) bestimmt wird.

12. Verfahren zur Überwachung einer Spuleneinheit nach Anspruch 10 oder Anspruch 11, **dadurch gekennzeichnet, dass** mittels einer Ausgabeeinheit das Diagnosesignal (S_{D}) visuell oder akustisch ausgegeben wird.

13. Verfahren zur Überwachung einer Spuleneinheit nach einem der Ansprüche 10 bis 12, **dadurch gekennzeichnet, dass** wenigstens eine Eigenschaft des Diagnosesignals (S_{D}) mit der Größe der Abweichung wenigstens eines der zur Bestimmung des Diagnosesignals (S_{D}) verwendeten Werte korreliert wird.

14. Verfahren zur Überwachung einer Spuleneinheit nach einem der Ansprüche 10 bis 13, **dadurch gekennzeichnet, dass** mehrere Diagnosesignale (S_{D}) bestimmt werden, wobei die einzelnen Diagnosesignale (S_{D}) jeweils mit einem Zeitstempel versehen werden.

15. Verfahren zur Überwachung einer Spuleneinheit nach einem der Ansprüche 10 bis 14, **dadurch gekennzeichnet, dass** zu mehreren Zeitpunkten Istwerte bestimmt werden.
